# EUROPEAN PATENT APPLICATION

(11) **EP 4 629 284 A1**
(43) Date of publication of application: **08.10.2025**
(21) Application number: 23897545.2
(22) Date of filing: 17.11.2023
(51) Int. Cl.: H01L 21/677

(54) **SUBSTRATE TRANSPORT METHOD AND SUBSTRATE TREATMENT SYSTEM**

(30) Priority: 01.12.2022 JP 2022193055
(71) Applicant: Tokyo Electron Limited, Tokyo 107-6325 (JP)
(72) Inventor: OKANO, Shinya, Nirasaki City, Yamanashi 407-0192 (JP); SUGIMOTO, Takashi, Nirasaki City, Yamanashi 407-0192 (JP)
(74) Representative: Hoffmann Eitle
(86) International application number: PCT/JP2023/041425
(87) International publication number: WO 2024/116894

(57) **Abstract**

A substrate transfer method includes (A) causing a transfer robot to hold a substrate and to load the substrate in an alignment module, and causing the transfer robot to mount the substrate on a stage of the alignment module based on the transfer robot moving past the stage of the alignment module; (B) causing the alignment module to measure an eccentricity of the substrate and estimating an amount of warpage of the substrate based on the measured eccentricity of the substrate; and (C) causing the substrate unloaded from the alignment module to be loaded in a different module based on the estimated amount of warpage of the substrate. The (A), (B), and (C) are performed in this order. In (A), the substrate is moved obliquely downward relative to a stage of the alignment module.

## Description

### TECHNICAL FIELD

The present disclosure relates to a substrate transfer method and a substrate processing system.

### BACKGROUND ART

In a substrate processing system, a substrate is transferred from an atmospheric transfer module to a vacuum transfer module and the substrate is processed in one or more processing modules connected to the vacuum transfer module. The atmospheric transfer module is provided with an alignment module (alignment apparatus) that measures the eccentricity of a preprocessed substrate and performs substrate alignment.

There is a case where a substrate subjected to processing in the substrate processing system may have warpage in a plane. Patent Document 1 discloses a technique of obtaining a luminance distribution pattern in a radial direction of a substrate by an imaging unit and predicting a warpage state of the substrate based on a relative elevation amount between the imaging unit and the substrate.

### RELATED ART DOCUMENTS

### PATENT DOCUMENT

Patent Document 1: Japanese Unexamined Patent Application Publication No. 2016-63028

### SUMMARY OF THE INVENTION

### PROBLEMS TO BE SOLVED BY THE INVENTION

The present disclosure provides a technique of easily and accurately estimating warpage of a substrate.

### MEANS FOR SOLVING THE PROBLEMS

According to an aspect of the present disclosure, there is provided a substrate transfer method includes (A) causing a transfer robot to hold a substrate and to load the substrate in an alignment module, and causing the transfer robot to mount the substrate on a stage of the alignment module based on the transfer robot moving past the stage of the alignment module; (B) causing the alignment module to measure an eccentricity of the substrate and estimating an amount of warpage of the substrate based on the measured eccentricity of the substrate; and (C) causing the substrate unloaded from the alignment module to be loaded in a different module based on the estimated amount of warpage of the substrate. The (A), (B), and (C) are performed in this order. In (A), the substrate is moved obliquely downward relative to a stage of the alignment module.

### EFFECTS OF THE INVENTION

According to one aspect, warpage of a substrate can be easily and accurately estimated.

### BRIEF DESCRIPTION OF THE DRAWINGS

[FIG. 1] FIG. 1 is a plan view illustrating a configuration of a substrate processing system according to a first embodiment.
[FIG. 2] FIG. 2 is an enlarged perspective view illustrating an end effector of a transfer robot.
[FIG. 3] FIG. 3 is a flowchart illustrating a processing flow of a substrate transfer method.
[FIG. 4] FIG. 4 is a diagram illustrating a substrate mounting operation in an alignment apparatus.
[FIG. 5] FIG. 5 is a diagram illustrating an operation of mounting a substrate W having convex warpage in the alignment apparatus.
[FIG. 6] FIG. 6(A) is a graph illustrating a result of measuring the position of the outer edge of a substrate without warpage by the alignment apparatus. FIG. 6(B) is a graph illustrating a result of measuring the position of the outer edge of a substrate having convex warpage by the alignment apparatus.
[FIG. 7] FIG. 7 is a side view for explaining the principle of estimating an amount of warpage from an eccentricity of the substrate.
[FIG. 8] FIG. 8 is a diagram illustrating a substrate mounting operation in a load lock module.
[FIG. 9] FIG. 9 is a diagram illustrating a mounting operation of an end effector of a substrate processing system according to a second embodiment.
[FIG. 10] FIG. 10(A) is a diagram illustrating an example in which a substrate having convex warpage is mounted by the mounting operation of the second embodiment. FIG. 10(B) is a diagram illustrating an example in which a substrate having concave warpage is mounted by the mounting operation of the second embodiment.
[FIG. 11] FIG. 11 is a graph illustrating a result of measuring the position of the outer edge of the substrate having concave warpage by the alignment apparatus.
[FIG. 12] FIG. 12 is an explanatory diagram illustrating a substrate processing system according to a modification.

### DESCRIPTION OF EMBODIMENTS

Hereinafter, embodiments for implementing the present disclosure will be described with reference to the drawings. In the drawings, the same components are denoted by the same reference numerals, and a duplicate description thereof may be omitted.

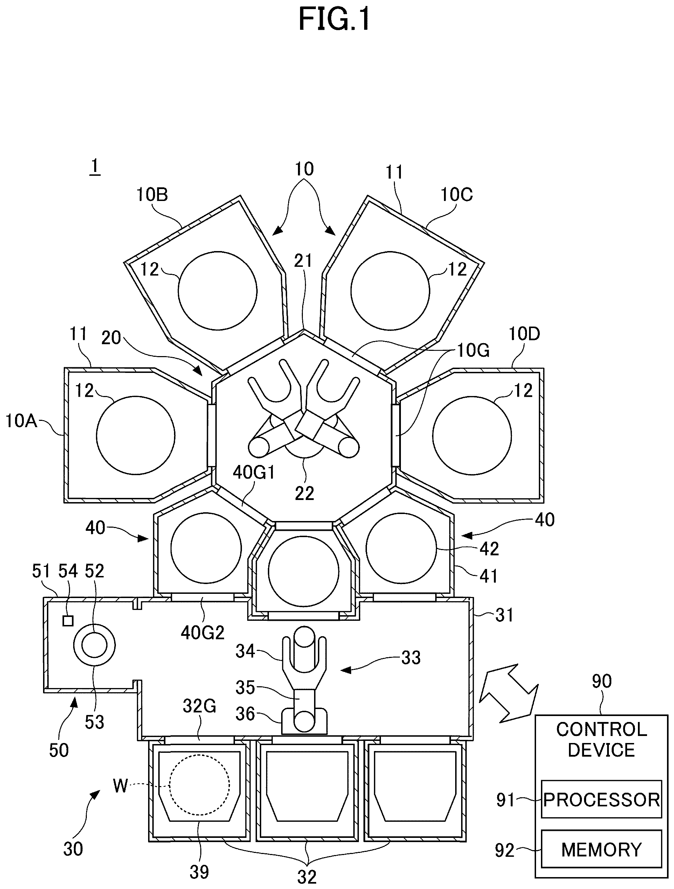

FIG. 1 is a plan view illustrating a configuration of a substrate processing system 1 according to the first embodiment. In FIG. 1, for convenience, some of the internal components of the apparatus are illustrated in a transparent manner. The substrate processing system 1 is a system that transfers a substrate W and performs various substrate processing on a substrate W. Examples of a substrate W processed in the substrate processing system 1 include a silicon wafer such as a single crystal silicon wafer, a silicon carbide wafer, or an SOI wafer, and a compound semiconductor wafer such as a GaAs wafer, a SiC wafer, a GaN wafer, or an InP wafer.

The substrate processing system 1 includes a plurality of processing modules 10, a vacuum transfer module 20, an atmospheric transfer module 30, and a plurality of load lock modules 40. The substrate processing system 1 further includes a control device 90 that controls each module.

Each of the plurality of processing modules 10 includes a processing container 11 for which a pressure can be decreased to a vacuum atmosphere and a stage 12 on which a substrate W is mounted in the processing container 11. Each processing module 10 performs various substrate processing (etching, film formation, ashing, etc.) on a substrate W accommodated in the processing container 11. In the present specification, the term "vacuum" means a pressure lower than the atmospheric pressure. The processing module 10 may be a plasma processing module that performs plasma processing on a substrate W. In FIG. 1, four processing modules 10 are illustrated, and these processing modules are also referred to as "processing modules 10A, 10B, 10C, and 10D" in a clockwise direction from a side close to the load lock module 40. The processing modules 10A, 10B, 10C, and 10D may perform the same type of substrate processing or may perform different types of substrate processing. The number of processing modules 10 is not limited to this example.

The vacuum transfer module 20 includes a vacuum transfer container 21 in which a vacuum transfer robot 22 for transferring a substrate W is installed. The plurality of processing modules 10 and the plurality of load lock modules 40 are connected to the vacuum transfer container 21. The vacuum transfer module 20 reduces a pressure in the vacuum transfer container 21 to a vacuum atmosphere, and transfers a substrate W between the processing module 10 and each load lock module 40 or between the plurality of processing modules 10 by the vacuum transfer robot 22. A gate valve 10G is provided between the vacuum transfer module 20 and each of the processing modules 10.

Each of the plurality of load lock modules 40 includes a load lock container 41 capable of loading and unloading a substrate W. Each of the load lock modules 40 is connected to the vacuum transfer module 20 via a gate valve 40G1 and is connected to the atmospheric transfer module 30 via a gate valve 40G2. In FIG. 1, the substrate processing system 1 includes three load lock modules 40 arranged between the vacuum transfer module 20 and the atmospheric transfer module 30, but the number of the load lock modules 40 is not particularly limited.

Each of the load lock containers 41 has an internal pressure variable chamber whose pressure can be switched between a vacuum atmosphere and an atmospheric atmosphere. The internal pressure variable chamber is provided with a stage 42 on which a substrate W can be mounted. In the case where a substrate W is transferred from the atmospheric transfer module 30 to the vacuum transfer module 20, the load lock module 40 receives the substrate W from the atmospheric transfer module 30 while maintaining the internal pressure variable chamber at atmospheric pressure, and then decrease the pressure in the internal pressure variable chamber and passes the substrate W to the vacuum transfer module 20. In the case where a substrate W is transferred from the vacuum transfer module 20 to the atmospheric transfer module 30, the load lock module 40 receives the substrate W from the vacuum transfer module 20 while maintaining the internal pressure variable chamber in a vacuum state to vacuum, and then passes the substrate W to the atmospheric transfer module 30 while increasing the pressure in the internal pressure variable chamber.

The atmospheric transfer module 30 constitutes a substrate transfer system for transferring a substrate W on the atmospheric side (in the atmospheric atmosphere) with respect to the atmosphere of the vacuum transfer module 20. The atmospheric transfer module 30 includes an atmospheric transfer container 31 in which an atmospheric transfer robot (hereinafter, simply referred to as a "transfer robot 33") is installed. The atmospheric transfer container 31 is formed in a rectangular shape in a plan view. A plurality of (three) load ports 32 and one alignment module (aligner module) 50 are connected to the atmospheric transfer container 31. The load ports 32 are arranged along a long side of the atmospheric transfer container 31 opposite to the other long side to which the load lock modules 40 are connected. The alignment module 50 is provided on one short side of the atmospheric transfer container 31. The atmospheric transfer module 30 may be, for example, an equipment front end module (EFEM). The atmospheric transfer module 30 may include a fan filter unit (FFU) that supplies clean air from the upper portion of the atmospheric transfer container 31, and an exhaust device that exhausts air.

A substrate storage case (substrate storage) 39, such as a front opening unified pod (FOUP) capable of storing a plurality of substrates W, is set in each of the plurality of load ports 32. An openable/closable gate 32G is provided between the atmospheric transfer container 31 and each of the load ports 32. Although three load ports 32 are provided in FIG. 1, the number of load ports 32 is not particularly limited.

The transfer robot 33 transfers a substrate W in the atmospheric transfer container 31. The transfer robot 33 includes, for example, an end effector 34 that directly holds a substrate W, a plurality of arms 35 that support the end effector 34 in such a manner that the position of the end effector 34 is displaceable, and a base 36 that supports the arms 35. The transfer robot 33 may be configured to be reciprocally movable along the longitudinal direction of the atmospheric transfer container 31 by a slide mechanism (not illustrated) provided on the base 36. The base 36 is provided with a lifting mechanism (not illustrated) capable of integrally moving the end effector 34 and the arms 35 along the vertical direction. The plurality of arms 35 relatively rotate with a joint portion connecting the arms 35 as a base point, and move the end effector 34 of the transfer robot 33 to a predetermined position in the horizontal direction. Although the transfer robot 33 illustrated in FIG. 1 is configured to transfer a substrate W by one end effector 34, the transfer robot 33 may be configured to transfer a substrate W by independently operating a plurality of end effectors 34.

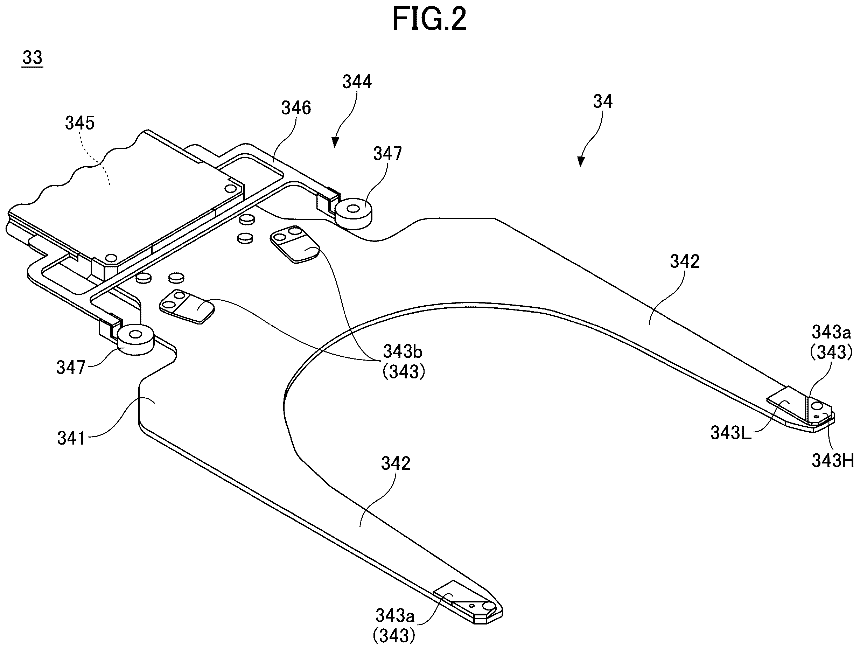

FIG. 2 is an enlarged perspective view of the end effector 34 of the transfer robot 33. The end effector 34 includes a base plate portion 341 and a pair of (two) fork plate portions 342. The base plate portion 341 and the pair of fork plate portions 342 are integrally formed with each other, and the upper surface and the lower surface of each portion are continued in a flat shape along the horizontal direction. The inner edges of the pair of fork plate portions 342 facing each other are curved and continuous via the arc-shaped edge at the distal end of the base plate portion 341.

The base plate portion 341 is attached to the distal-side arm 35 among the plurality of arms 35. The pair of fork plate portions 342 extend substantially linearly from the base plate portion 341 toward the distal end (in the direction opposite to the distal-side arm 35). A plurality of (four) contact pads 343 with which a substrate W comes into contact are attached to the upper surface of the end effector 34.

The four contact pads 343 are provided one each at each of the extending ends (distal ends) of the fork plate portions 342, and two contact pads are provided at the center portion in the width direction of the base plate portion 341. Hereinafter, the contact pads 343 respectively provided at the extending ends of the fork plate portions 342 may be referred to as the "contact pads 343a", and the contact pads 34 respectively provided on the base plate portion 341 may be referred to as the "contact pads 343b".

The upper surface of each contact pad 343 is constituted by a low floor portion 343L and a high floor portion 343H, and has a guide step at the boundary between the low floor portion 343L and the high floor portion 343H. Each contact pad 343 has a guide step which is an arc-shaped boundary shared by the other contact pads 343, and the guiding step can form a virtual circle having a diameter slightly larger than the outer diameter (diameter) of a substrate W. The end effector 34 supports a substrate inside the guide step by each contact pad 343. Specifically, the outer edge of a substrate W is guided by the boundary wall with the high floor portion 343H while the lower surface of the substrate W is brought into contact with the low floor portion 343L.

The end effector 34 further includes a clamp mechanism 344 that clamps a substrate W between the contact pads 343 of the fork plate portions 342. The clamp mechanism 344 includes an advance/withdrawal driver 345 attached to the end effector 34 (or the arm 35), a frame body 346 that is caused to advance and withdraw by the advance/withdrawal driver 345, and a pair of (two) rollers 347 fixed to the frame body 346. The advance/withdrawal driver 345 has a drive source (not illustrated) such as a cylinder mechanism, and advances and withdraws the frame body 346 under the drive of the drive source. The frame body 346 includes a pair of vertical frames extending in parallel to the longitudinal direction of the end effector 34 (the extending direction of the pair of fork plate portions 342), and a horizontal frame bridging the pair of vertical frames. The pair of rollers 347 are provided at the extending end (one end) of the pair of vertical frames, respectively. The pair of rollers 347 are arranged to be rotatable at the same height as a substrate W arranged on the low floor portion 343L of each contact pad 343.

The clamp mechanism 344 configured as described above causes the frame body 346 to advance by the advance/withdrawal driver 345, with a substrate W being mounted on the contact pads 343. When the pair of rollers 347 comes into contact with the outer edge of a substrate W by the advance of the frame body 346, the substrate W is pushed out in the distal end direction. The end effector 34 inserts the outer edge of the substrate W between the guide steps provided on the contact pads 343a of the pair of fork plate portions 342 and the pair of rollers 347. Thus, the holding position of the substrate W is defined at a position where the substrate W is in contact with the pair of contact pads 343a. Using the clamp mechanism 344 allows the transfer robot 33 to hold and stably transfer a substrate W in a constant holding form (posture, position, etc.) of a substrate W in the end effector 34.

Returning to FIG. 1, the alignment module 50 connected to the atmospheric transfer module 30 aligns a substrate W transferred by the transfer robot 33. The alignment module 50 includes, for example, a housing 51 capable of accommodating a substrate W, a rotary stage 52 provided in the housing 51 and on which a substrate W can be mounted, a rotary drive mechanism 53 for rotating the rotary stage 52, and an optical sensor 54 for optically detecting the outer edge of a substrate W.

The housing 51 is formed in a rectangular parallelepiped box shape, and an inner space of the housing 51 is open to the atmospheric transfer container 31. Thus, the transfer robot 33 is configured to be able to access (advances to and withdraws from) the internal space of the housing 51.

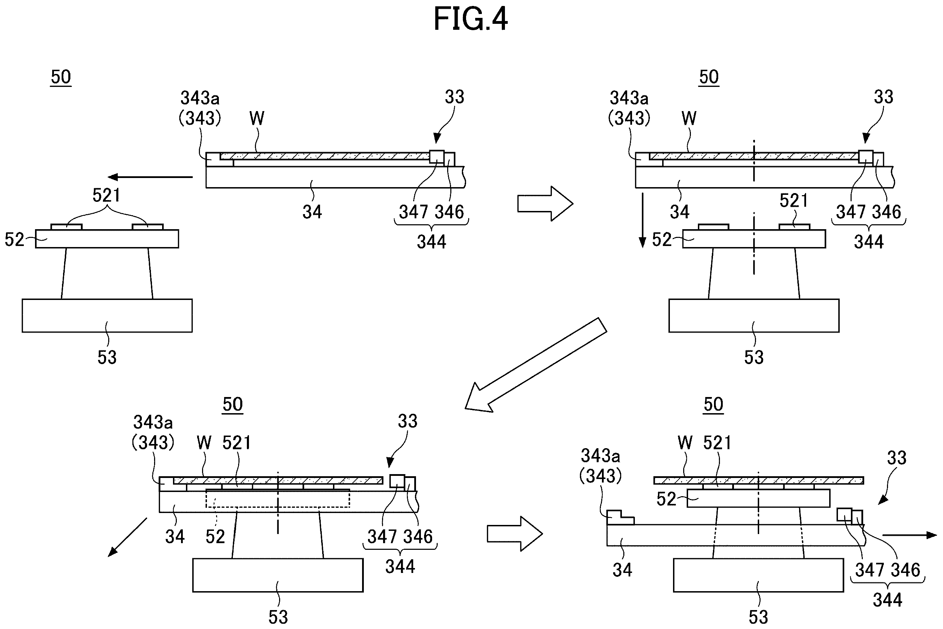

The rotary stage 52 is formed in a disk shape having a diameter smaller than the diameter of a substrate W and the distance between the pair of fork plate portions 342 of the end effector 34. A rotation shaft of the rotary drive mechanism 53 is connected to a center position of the lower surface of the rotary stage 52. A plurality of holding pads 521 (see FIG. 4) for holding the lower surface of a substrate W are formed to protrude from the upper surface of the rotary stage 52. In this case, the upper surface of each holding pad 521 constitutes a mounting surface on which a substrate W is mounted. Each of the holding pads 521 may be connected to a suction mechanism (not illustrated) and may be configured to suck a substrate W by applying a suction pressure from the suction mechanism. Alternatively, the rotary stage 52 may be configured to fix a substrate W by other holding means (such as an electrostatic chuck). The rotary stage 52 may have a flat mounting surface without the holding pads 521.

The center portion of a substrate W is mounted on the rotary stage 52 through transfer by the transfer robot 33. The rotary stage 52 rotates a substrate W mounted on the mounting surface of the rotary stage 52 through the rotation of the rotary drive mechanism 53 under the command of the control device 90.

The optical sensor 54 is provided on the outer periphery of the rotary stage 52, and optically detects the outer edge of a substrate W during rotation and detects the position of a notch (or an orientation flat) formed in the substrate W. For example, the optical sensor 54 includes a light projector that emits measurement light and a light receiver that receives the measurement light of the light projector, and detects the outer edge of a substrate W based on the light amount of the measurement light blocked by the outer edge of the substrate W. Thus, the control device 90 calculates the orientation of a substrate W in the circumferential direction, the eccentricity, and the like based on the position of the outer edge of the substrate W during rotation of the substrate W.

The control device 90 of the substrate processing system 1 is a computer that includes one or more processors 91, a memory 92, and an input/output interface and a communication interface (not illustrated) and controls the entire system. In the following description, an example in which the substrate processing system 1 controls the operation of each module by the control device 90 will be described. Therefore, the control device 90 also functions as a controller of the atmospheric transfer module 30 or the alignment module 50, which are the substrate transfer system. Not being limited to this example, the substrate processing system 1 may be configured to include dedicated controllers (not illustrated) for respective modules and to cause each controller to operate each module based on a control command of the control device 90.

The one or more processors 91 are one or a combination of a central processing unit (CPU), a graphics processing unit (GPU), an application specific integrated circuit (ASIC), a field-programmable gate array (FPGA), a circuit including a plurality of discrete semiconductors, and the like, and execute a program stored in the memory 92. The memory 92 includes a nonvolatile memory and a volatile memory (for example, a compact disc, a digital versatile disc (DVD), a hard disk, a flash memory, or the like), and forms a storage of the control device 90.

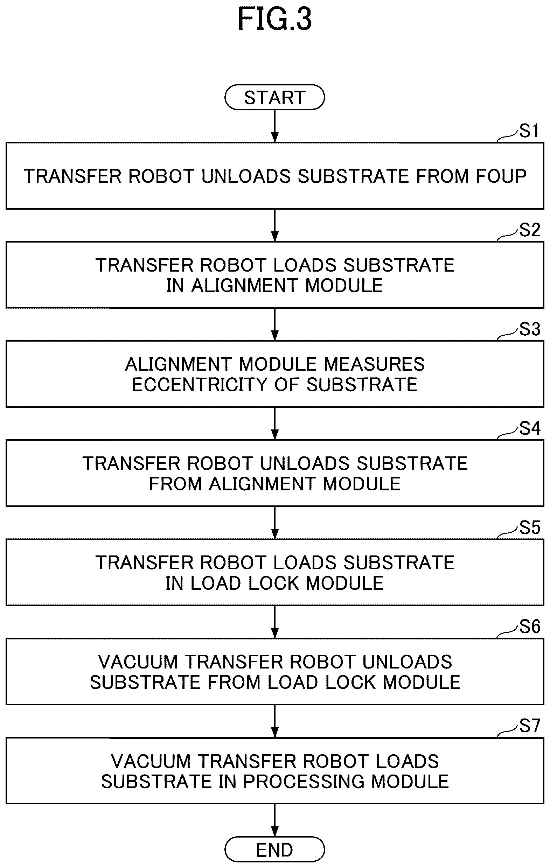

The processor 91 controls the operation of the transfer robot 33 and the operation of each module by reading and executing the program stored in the memory 92. Hereinafter, the operation control of the control device 90 when a substrate W is transferred from the atmospheric transfer module 30 to the vacuum transfer module 20 will be described with reference to FIG. 3. FIG. 3 is a flowchart illustrating a processing flow of transfer of a substrate W.

When causing a substrate W to be transferred from the atmospheric transfer module 30 to the target processing module 10, the control device 90 performs steps S1 through S7 in this order to perform transfer and alignment of a substrate W in the atmospheric transfer module 30. The control device 90 first causes the transfer robot 33 to unload a substrate W from the substrate storage case 39 that is set in the predetermined load port 32 (step S1).

Next, the control device 90 causes the transfer robot 33 to transfer the substrate W and load the substrate W in the alignment module 50 (step S2). At this time, the transfer robot 33 performs a mounting operation in the housing 51 to mount the substrate W on the upper surface of the rotary stage 52.

FIG. 4 is a diagram illustrating an operation of mounting the substrate W in the alignment module 50. In the mounting operation, the control device 90 controls the movement direction and the position of the transfer robot 33 in accordance with the operation order illustrated in FIG. 4.

Specifically, as illustrated in the upper left diagram of FIG. 4, the control device 90 first causes the end effector 34 of the transfer robot 33 to move in the horizontal direction in the alignment module 50. In other words, the substrate W held by the end effector 34 advances in parallel to the mounting surface of the rotary stage 52. At this time, the end effector 34 has the substrate W inserted between the contact pads 343 and the rollers 347 by causing the frame body 346 and the rollers 347 of the clamp mechanism 344 to advance, and transfers the substrate W in this state. The end effector 34 is thereby able to stably transfer the substrate **W.**

Then, as illustrated in the upper right diagram of FIG. 4, the control device 90 stops the horizontal movement of the transfer robot 33 at a position where the center of the substrate W and the rotation center of the rotary stage 52 coincide with each other. The control device 90 has in advance coordinate information regarding the rotation center of the rotary stage 52 and recognizes information regarding the center of the substrate W held by the end effector 34 of the transfer robot 33. As described above, since the substrate W is inserted in the end effector 34, the center of the substrate W with respect to the end effector 34 can be always constant. Thus, the control device 90 causes the end effector 34 to horizontally move through the feedforward control when the substrate W is loaded in, so that the horizontal movement of the substrate W can be completed at a position where the center of the substrate W and the rotation center of the rotary stage 52 coincide with each other.

The end effector 34 may withdraw the frame body 346 and the rollers 347 and of the clamp mechanism 344 at a position where the substrate W has moved to a position directly above the rotary stage 52, and release the substrate W from being clamped by the clamp mechanism 344. Thus, the substrate W is in a state where it can be released from the end effector 34.

Next, the control device 90 causes the end effector 34 of the transfer robot 33 to lower downward in the vertical direction. At this time, the transfer robot 33 lowers the end effector 34 so that the rotary stage 52 passes between the pair of fork plate portions 342. The control device 90 has coordinate information of the height of the mounting surface of the rotary stage 52 (holding pads 521) in advance. For this reason, the control device 90 causes the end effector 34 to lower along the vertical direction until the position of the lower surface of the substrate W held by the end effector 34 and the coordinate position of the mounting surface of the rotary stage 52 coincide with each other.

In the case where the control device 90 recognizes that the position of the lower surface of the substrate W and the coordinate position of the mounting surface of the rotary stage 52 coincide with each other, the control device 90 switches the current operation to an operation of moving the end effector 34 obliquely downward with respect to the vertical direction as illustrated in the lower left diagram of FIG. 4. In other words, if the end effector 34 were to continue lowering downward in the vertical direction, there would be a possibility that the contact pads 343a of the end effector 34 and the outer edge of the substrate W may interfere with each other and rub the outer edge of the substrate **W.** This rubbing increases the risk of positional displacement of the substrate W and generation of particles.

By causing the end effector 34 to move obliquely downward, it is possible, on the other hand, to immediately separate the end effector 34 (each contact pad 343a) from the outer edge of the substrate W to avoid mutual interference. Specifically, the end effector 34 moves in the advancing direction of the end effector 34 with respect to the alignment module 50 and toward the lower side in the vertical direction. This is because the distal end side of the outer edge of the substrate W is in contact with each contact pad 343a of each fork plate portion 342 in a clamp release state of the clamp mechanism 344.

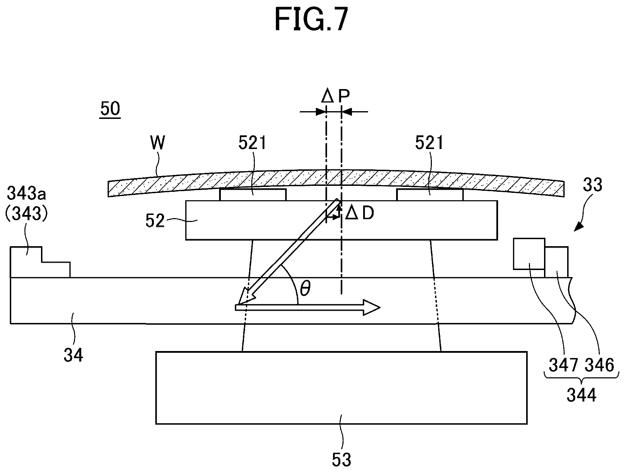

An angle θ (see FIG. 7) of the moving direction of the end effector 34 with respect to the horizontal direction is not particularly limited as long as interference between the end effector 34 and the substrate W can be stably avoided, and may be set to, for example, a range of about 30° to 85°. In the present embodiment, the angle θ of the moving direction is set to 45°.

The substrate W is mounted on the rotary stage 52 by the position of the end effector 34 becoming lower than the mounting surface of the rotary stage 52. The control device 90 performs the obliquely downward movement of the end effector 34 over a predetermined distance. Thereafter, as illustrated in the lower right diagram of FIG. 4, the control device 90 causes the end effector 34 to withdraw along the horizontal direction at a height position lower than the rotary stage 52. Thus, the end effector 34 can exit in a state where the substrate W is loaded in the alignment module 50.

Returning to FIG. 3, after the substrate W is loaded in the alignment module 50, the control device 90 causes the rotary stage 52 to rotate to measure the eccentricity and the position of the notch of the substrate W (step S3). Thus, the control device 90 calculates the orientation and the positional displacement of the substrate W in the circumferential direction, and appropriately controls the movement of the transfer robot 33 or the operation of the rotary stage 52, so that the substrate W in which the orientation and the positional displacement in the circumferential direction are improved is transferred.

The control device 90 causes the transfer robot 33 to enter the alignment module 50, receive the substrate W from the rotary stage 52, and unload the substrate W from the alignment module 50 (step S4). At the time of receiving the substrate W, the control device 90 corrects the movement of the transfer robot 33 in accordance with the orientation in the circumferential direction and the positional displacement calculated by the alignment module 50 so that the transfer robot 33 can receive the substrate W.

Then, the control device 90 causes the transfer robot 33 to load the substrate W unloaded from the alignment module 50 in the load lock module 40 (step S5). When the substrate W is mounted on the stage 42 of the load lock module 40, the control device 90 may correct the movement of the transfer robot 33 in accordance with the orientation in the circumferential direction and the positional displacement calculated by the alignment module 50 and so that the substrate W is transferred and received.

Thereafter, the control device 90 causes the pressure inside the load lock module 40 in which the substrate W is loaded to decrease to a vacuum atmosphere, and then causes the vacuum transfer robot 22 to unload the substrate W from the load lock module 40 (step S6). Further, the control device 90 causes the vacuum transfer robot 22 to load the substrate W in the target processing module 10 by (step S7). Similarly, in the case where the substrate W is mounted on the stage 12 of the processing module 10, the control device 90 may correct the movement of the vacuum transfer robot 22 in accordance with the orientation in the circumferential direction and the positional displacement calculated by the alignment module 50 and so that the substrate W is transferred and received.

As described above, the substrate processing system 1 measures the eccentricity and the position of the notch of the substrate W in the alignment module 50, so that the substrate W aligned to the load lock module 40 can be transferred. Thus, the substrate processing system 1 can accurately mount the substrate W on the stage 12 of the processing module 10 and stably perform substrate processing by the processing module 10.

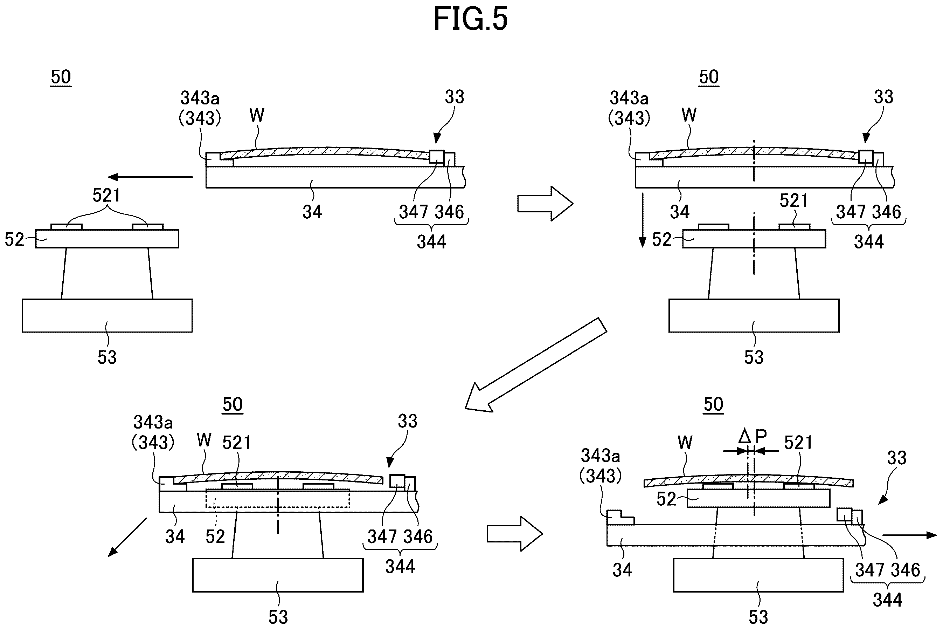

There is a case where a substrate W to be processed in the substrate processing system 1 may have warpage. For example, a plurality of films are stacked on a substrate W, and a stress applied to the substrate W during film formation due to a difference in thermal expansion between the films causes warpage in the substrate W. As an example, as illustrated in FIG. 5, warpage of the substrate W may be formed in such a manner that the vicinity of the center of the substrate W is higher than the outer edge of the substrate W, in other words, the vicinity of the center of the substrate W is convex upward in the vertical direction (hereinafter, such a form is referred to as "convex warpage"). FIG. 5 is a diagram illustrating an operation of mounting a substrate W having convex warpage in the alignment module 50.

The substrate processing system 1 performs the above-described mounting operation also on the substrate W having convex warpage when the substrate W is transferred by the transfer robot 33 and loaded in the alignment module 50. In this mounting operation, the substrate processing system 1 mounts the substrate W with a positional displacement with respect to the mounting surface of the rotary stage 52 when the end effector 34 is moved obliquely downward.

Specifically, as illustrated in the upper left and upper right diagrams of FIG. 5, the control device 90 performs an operation of sliding the end effector 34 in the horizontal direction, and then performs an operation of lowering the end effector 34 downward in the vertical direction. When the end effector 34 is lowered, the control device 90 causes the end effector 34 to move by a movement distance (lowering distance) at which the height position of the lower surface of the substrate W based on the position information regarding the end effector 34 and the height position of the mounting surface of the rotary stage 52 coincide with each other.

However, the lower surface of the substrate W having convex warpage is warped in a direction away from the holding pads 521. For this reason, even when the position of the lower surface of the substrate W and the coordinate position of the mounting surface of the rotary stage 52 coincide with each other in the position information regarding the end effector 34 in the control device 90, the lower surface of the actual substrate W is not in contact with the mounting surface of the rotary stage 52 as illustrated in the lower left diagram of FIG. 5.

Therefore, when the end effector 34 moves obliquely downward next time, the substrate W having convex warpage also moves obliquely downward integrally with the end effector 34. The substrate W having convex warpage is held on the rotary stage 52 by coming into contact with the mounting surface of the rotary stage 52 when moving obliquely downward. On the other hand, the end effector 34 continues to move obliquely downward.

As illustrated in the lower right diagram of FIG. 5, the substrate W having convex warpage is mounted in a state of being displaced in the advancing direction of the end effector 34 (the depth direction of the alignment module 50) with respect to the mounting surface of the rotary stage **52.** An amount of positional displacement ΔP generated when the substrate W having convex warpage is mounted corresponds to an eccentricity, which is a deviation of the center of the substrate W from the center of the rotary stage **52.**

The amount of convex warpage (amount of warpage) generated in a substrate W can be expressed by a difference between the center of the lower surface (or upper surface) of a substrate W and the outer edge of the lower surface (or upper surface) of a substrate W. The substrate W demonstrates minimal warpage within a range of approximately 10 µm to 1 mm. This limited warpage range precludes reliable pre-assessment of the amount of warpage of a substrate W by visual recognition or the like without using a device for measuring the shape of a substrate W. In the case where a substrate W is displaced due to an influence of warpage of a substrate W, the substrate W is transferred in a displaced state even after the substrate W is transferred from the atmospheric transfer module 30 to the vacuum transfer module 20. Therefore, the substrate processing system 1 according to the present embodiment is configured to measure an eccentricity of a substrate W with the alignment module 50, estimate an amount of warpage of the substrate W by using the eccentricity, and eliminate a positional displacement according to the amount of warpage of the substrate W.

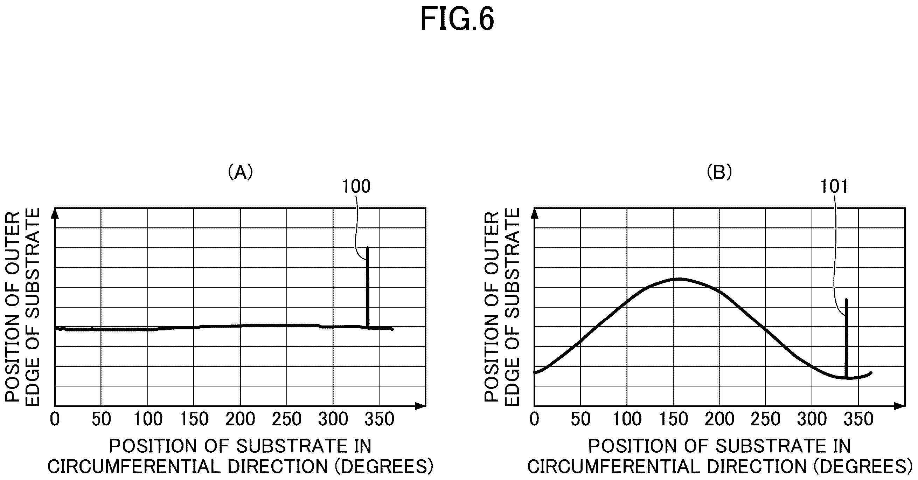

Hereinafter, a method of estimating an amount of warpage of a substrate W will be described with reference to FIGS. 6 and 7. FIG**.** 6(A) is a graph illustrating a result of measuring the position of the outer edge of a substrate W without warpage by the alignment module 50. FIG. 6(B) is a graph illustrating a result of measuring the position of the outer edge of a substrate W having convex warpage by the alignment module 50. FIG. 7 is a side view for explaining the principle of estimating an amount of warpage from an eccentricity of a substrate W.

The alignment module 50 measures the position of the outer edge of a substrate W having no warpage by the optical sensor 54 while rotating the rotary stage 52. In this case, as illustrated in FIG. 6(A), the position of the outer edge of the substrate W exhibits a sufficiently small amplitude (or the amplitude becomes zero). The peak 100 that suddenly protrudes in the graph of FIG. 6(A) and the peak 101 that suddenly protrudes in the graph of FIG. 6(B) are positions at which the notch formed in the outer edge of the substrate W is detected.

As described above, the end effector 34 of the transfer robot 33 according to the present embodiment transfers the substrate W, with the substrate W being inserted. For this reason, even in the case where a plurality of different substrates W are transferred, the end effector 34 can always load a substrate W held at the same position in the alignment module 50 and mount the substrate W on the rotary stage 52. Even if the position of the outer edge of the substrate W mounted on the rotary stage 52 in the circumferential direction is slightly changed due to a distortion of the outer edge of the substrate W itself, the amplitude exhibited by the position of the outer edge in the measurement result of the alignment module 50 is sufficiently small.

In contrast, in the case where the position of the outer edge of the substrate W having convex warpage is measured by the alignment module 50, the amplitude of the outer edge of the substrate W increases as illustrated in FIG. 6(B). In other words, the end effector 34 loads substrates W held at the consistently same position in the alignment module 50, but a substrate W having convex warpage is decentered with respect to the rotary stage 52 by the above-described mounting operation. Therefore, an amplitude exhibited by the position of the outer edge greatly differs between the case where the position of the outer edge of a substrate W having no warpage is measured and the case where the position of the outer edge of a substrate W having convex warpage is measured.

An amount of positional displacement ΔP (eccentricity) of the center of the substrate W having convex warpage with respect to the rotation center of the rotary stage 52 changes according to an amount of convex warpage. The control device 90 calculates an amount of positional displacement ΔP of the substrate W by using the measurement result of the position of the outer edge of the substrate W having convex warpage illustrated in FIG. 6(B), and estimates (calculates) the amount of warpage of the substrate W based on the amount of positional displacement ΔP.

Specifically, as illustrated in FIG. 7, the end effector 34 mounts the substrate W having convex warpage on the rotary stage 52 when moving obliquely downward from the position at which the substrate W is to be mounted in the mounting operation. Therefore, the amount of positional displacement ΔP of the substrate W having convex warpage varies depending on the angle θ of the moving direction of the end effector 34. For example, in the case where the angle θ of the moving direction is large, the end effector 34 moves along a path close to the vertical direction, and the amount of positional displacement ΔP is small. Conversely, in the case where the angle θ of the movement direction is small, the end effector 34 moves away from the vertical direction, and the amount of positional displacement ΔP increases.

The angle θ of the obliquely downward moving direction of the end effector 34 is a preset value (45° in the present embodiment). In the case where the angle θ of the moving direction is 45°, the amount of positional displacement ΔP of the substrate W corresponds to the distance ΔD (i.e., the amount of warpage) from the lower surface of the substrate W to be mounted to the lower surface of the actual substrate W which has risen due to the warpage. In other words, the amount of positional displacement ΔP = the distance ΔD. In this way, the control device 90 can estimate an amount of warpage of a substrate W based on a calculation of an eccentricity of the substrate W by the alignment module 50. Even when the angle θ of the moving direction of the end effector 34 is other than 45°, an amount of warpage of the substrate W can be estimated by calculating an amount of positional displacement ΔP × tan θ.

Then, the control device 90 uses the estimated amount of warpage of the substrate W to command the transfer robot 33 to perform movement correction, thereby eliminating the positional displacement of the substrate W. For example, the control device 90 transfers the substrate W from the alignment module 50 to the load lock module 40 after measuring the eccentricity of the substrate W by the alignment module 50 (see step S5 in FIG. 3). When the substrate W is mounted on the stage 42 of the load lock module 40 by the transfer robot 33, movement is corrected according to the amount of warpage of the substrate W.

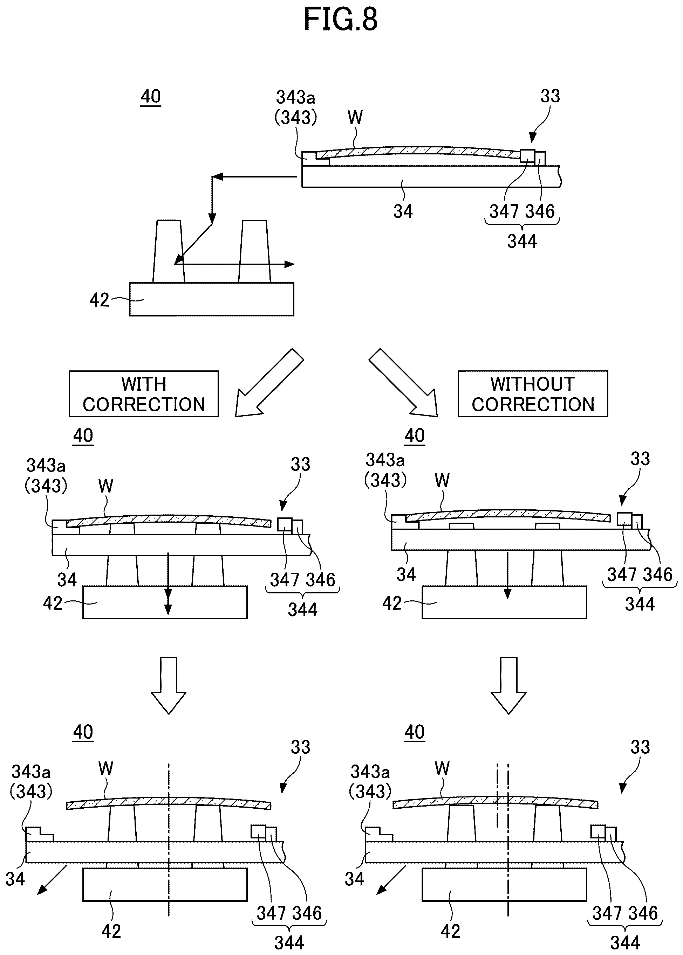

FIG. 8 is a diagram illustrating a mounting operation of the substrate W in the load lock module 40. As illustrated in the upper diagram of FIG. 8, the control device 90 performs the same mounting operation in the load lock module 40 as the mounting operation in the alignment module 50. This can avoid an occurrence of positional displacement and particles due to rubbing between the end effector 34 and the outer edge of the substrate W.

Specifically, the control device 90 performs an operation of sliding the end effector 34 in the horizontal direction in the load lock module 40, and then performs an operation of lowering the end effector 34 downward in the vertical direction. When the end effector 34 is lowered, the control device 90 causes the end effector 34 to move by a movement distance (lowering distance) at which the height position of the lower surface of the substrate W based on the position information regarding the end effector 34 and the height position of the mounting surface of the stage 42 coincide with each other.

The control device 90 performs movement correction according to the amount of warpage of the substrate W having convex warpage when the end effector 34 is lowered. The two diagrams on the left side of FIG. 8 illustrate the mounting operation of the substrate W having convex warpage subjected to the movement correction, and the two diagrams on the right side of FIG. 8 illustrate the mounting operation of the substrate W having convex warpage not subjected to the movement correction as a comparative example.

In the case where the movement correction is not performed, the end effector 34 starts to move obliquely downward in a state where the lower surface of the substrate W having convex warpage is not in contact with the mounting surface of the stage 42. For this reason, the substrate W having convex warpage is mounted in a state of being displaced with respect to the stage 42.

In contrast, the control device 90 adds the estimated amount of warpage of the substrate W having convex warpage to the preset movement distance of the end effector 34 when the end effector 34 is lowered. Thus, in the case where the movement correction is performed, the movement distance of the end effector 34 is increased by the amount of warpage as compared with the case where the movement correction is not performed. As a result, the lowering of the end effector 34 can be stopped at a position where the lower surface of the substrate W and the mounting surface of the stage 42 are just in contact with each other. Thereafter, even if the end effector 34 moves obliquely downward, the substrate W is maintained at the mounting position of the stage 42.

In other words, the substrate processing system 1 can mount the substrate W in a state where the center of the substrate W having convex warpage and the center of the stage 42 coincide with each other in the load lock module 40 by performing the movement correction. Therefore, the vacuum transfer robot 22 of the vacuum transfer module 20 can take out the substrate W accurately mounted in the load lock module 40 and transfer the substrate W to any of the processing modules 10A through 10D. The substrate processing system 1 may perform the movement correction according to the amount of warpage of the substrate W even in the case where the substrate W having convex warpage is loaded to the processing modules 10A through 10D by the vacuum transfer robot 22. Thus, the substrate processing system 1 can more accurately mount the substrate W having convex warpage on the stage 12.

The substrate processing system 1 according to the present embodiment is not limited to the above-described embodiment, and various modifications can be made. For example, the control device 90 according to the above-described embodiment converts a measurement result (an eccentricity of a substrate W) of the alignment module 50 into an amount of warpage of a substrate W as it is, and performs the movement correction according to the amount of warpage. However, the control device 90 may have a threshold value to be compared with the eccentricity of the substrate W, and may be configured to compare the eccentricity measured by the alignment module 50 with the threshold value. The control device 90 does not perform the movement correction in the case where the eccentricity is less than the threshold value, and performs the movement correction in the case where the eccentricity is equal to or more than the threshold value. By comparing the eccentricity with the threshold value in this way, it is possible to exclude a change in the eccentricity due to distortion of the outer edge itself of the substrate W, and it is possible to favorably correct the movement of only the substrate W in which warpage has occurred.

### (Second Embodiment)

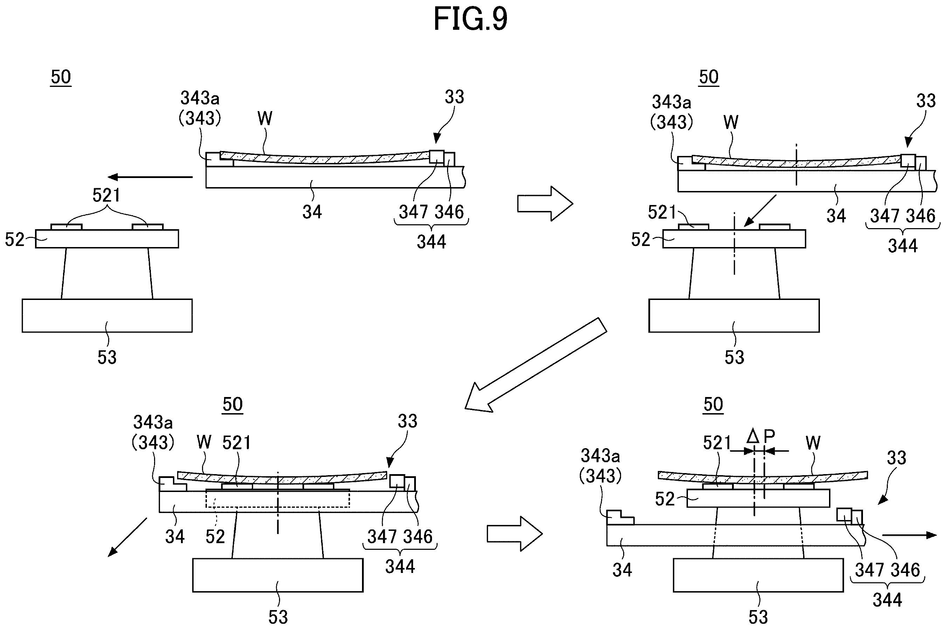

Warpage of a substrate W may be formed in such a manner that the vicinity of the center of the substrate W is lower than the outer edge of the substrate W, in other words, the vicinity of the center of the substrate W is concave downward in the vertical direction (hereinafter, such a form is referred to as "concave warpage"). Therefore, the substrate processing system 1 according to the second embodiment is configured to estimate the amount of warpage by distinguishing between the substrate W having convex warpage and the substrate W having concave warpage. FIG. 9 is a diagram illustrating a mounting operation of the end effector 34 of the substrate processing system 1 according to the second embodiment. Specifically, the substrate processing system 1 according to the second embodiment performs an obliquely downward movement in the mounting operation of the end effector 34 for a time longer than the mounting operation according to the first embodiment.

As illustrated in the upper left diagram of FIG. 9, the control device 90 first causes the end effector 34 of the transfer robot 33 to move in the horizontal direction in the alignment module 50. Then, as illustrated in the upper right diagram of FIG. 9, the control device 90 stops the horizontal movement of the transfer robot 33 at a slide stop position, which is a position before a position where the center of the substrate W and the rotation center of the rotary stage 52 coincide with each other.

The slide stop position is set to a position where the position of the lower surface of the substrate W (coordinate position in the Z-axis direction) and the coordinate position of the mounting surface of the rotary stage 52 coincide with each other and where the center of the substrate W coincides with the rotation center of the rotary stage 52, when the end effector 34 is moved obliquely downward in the next step. Since the control device 90 defines the angle θ of the obliquely downward moving direction in advance, the control device 90 can also calculate the slide stop position in advance, and can continuously move the end effector 34 obliquely downward based on the slide stop position.

The control device 90 causes the end effector 34 of the transfer robot 33 to move obliquely downward from the slide stop position. The control device 90 holds information on the coordinate position of the mounting surface of the rotary stage 52 in advance, and can recognize a position where the position of the lower surface of the substrate W held by the end effector 34 and the coordinate position of the mounting surface of the rotary stage 52 coincide with each other when the substrate W moves obliquely downward (see the lower left diagram of FIG. 9). However, even in a state where the lower surface of the substrate W is in contact with the mounting surface of the rotary stage 52 and it is recognized that the substrate W is mounted on the rotary stage 52, the substrate W is reliably released from the end effector 34 by continuing the obliquely downward movement.

In other words, the control device 90 performs the obliquely downward movement of the end effector 34 over a long distance from the slide stop position. Thereafter, as illustrated in the lower right diagram of FIG. 9, the control device 90 causes the end effector 34 to withdraw along the horizontal direction at a height position lower than the rotary stage 52. Thus, the end effector 34 can exit in a state where the substrate W is loaded in the alignment module 50.

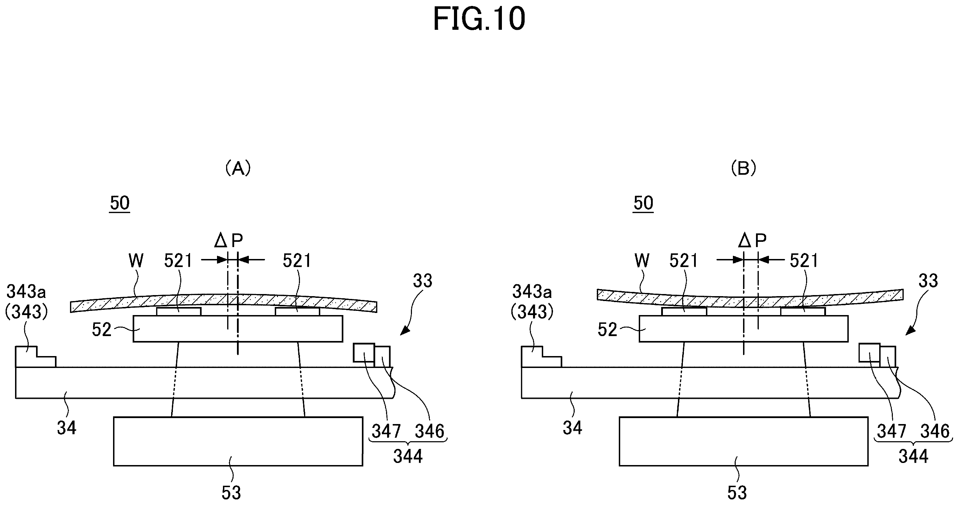

FIG. 10(A) is a diagram illustrating an example in which a substrate W having convex warpage is mounted by the mounting operation of the second embodiment. FIG. 10(B) is a diagram illustrating an example in which a substrate W having concave warpage is mounted by the mounting operation of the second embodiment. In the mounting operation of the second embodiment, the substrate W having convex warpage is mounted in a state where the substrate W is displaced from the rotation center of the rotary stage 52 to the back side in the traveling direction of the end effector 34. This is because, as described above, the obliquely downward movement by the end effector 34 continues at the position where the position of the lower surface of the substrate W and the coordinate position of the mounting surface of the rotary stage 52 coincide with each other.

On the other hand, in the mounting operation of the second embodiment, the substrate W having concave warpage is mounted on the mounting surface before the position of the lower surface of the substrate W recognized by the control device 90 and the coordinate position of the mounting surface of the rotary stage 52 coincide with each other because the center side of the lower surface protrudes from the outer edge. For this reason, the substrate W having concave warpage is mounted in a state of being displaced to the front side in the traveling direction of the end effector 34 with respect to the rotation center of the rotary stage 52.

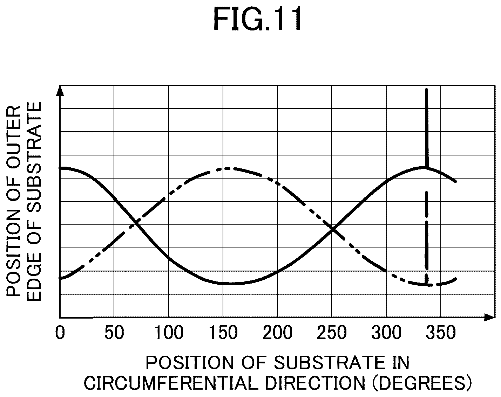

FIG. 11 is a graph illustrating a result of measuring the position of the outer edge of the substrate W having concave warpage by the alignment module 50. In FIG. 11, the two-dot chain line indicates the result of measuring the position of the outer edge of the substrate W having convex warpage. In the case where the position of the outer edge of the substrate W having concave warpage is measured, the alignment module 50 detects the position of the outer edge as indicated by a solid line in FIG. 11. For example, in the case where the amount of warpage is the same, the substrate W having convex warpage and the substrate W having concave warpage exhibit such an amplitude that the phase at the position of the outer edge of the substrate W is shifted by exact 180°.

Therefore, the control device 90 can determine whether the substrate W has convex warpage or concave warpage by ascertaining the phase in the circumferential direction of the position of the outer edge of the substrate W. The control device 90 can calculate the eccentricity (the amount of positional displacement ΔP) of the substrate W from the amplitude of the position of the outer edge of the substrate W. In this case, the amount of positional displacement ΔP of the substrate W having concave warpage may be calculated as a negative number with respect to the amount of positional displacement ΔP of the substrate W having convex warpage. Furthermore, the control device 90 can estimate the amount of warpage of the substrate W having convex warpage or the amount of warpage (negative value) of the substrate W having concave warpage based on the eccentricity. In other words, the control device 90 measures the position of the outer edge of the substrate W by the alignment module 50 after the mounting operation of the end effector 34 is performed, and it is thus possible to simply and accurately estimate the direction of the warpage (convex warpage or concave warpage) of the substrate W and the amount of warpage of the substrate W.

In the substrate processing system 1, in the case where the substrate W having concave warpage is known in advance, the end effector 34 may be moved obliquely downward before the substrate W is mounted on the mounting surface of the rotary stage 52, and the end effector 34 may be moved downward in the vertical direction after the coincidence between the position of the lower surface of the substrate W and the coordinate position of the mounting surface of the rotary stage 52 is recognized. Even in this case, the control device 90 can accurately calculate the amount of warpage of the substrate W having concave warpage.

### (Modifications)

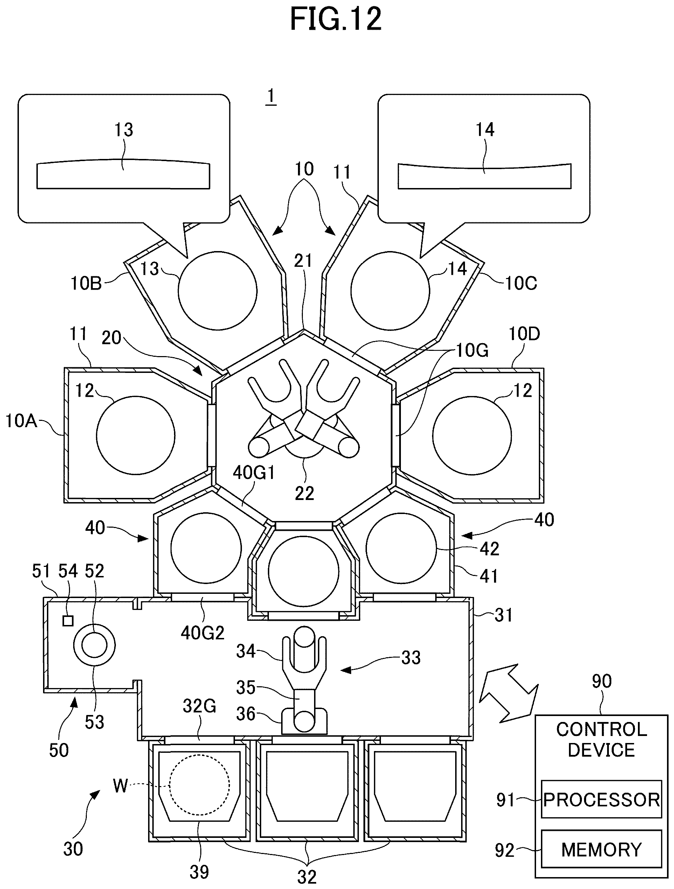

FIG. 12 is an explanatory diagram illustrating a substrate processing system 1A according to a modification. In the substrate processing system 1A, each of the processing modules 10A through 10D may include stage 13 or 14 that each conforms to a direction of warpage (convex warpage or concave warpage) of a substrate W. In the example of FIG. 12, the processing module 10B includes a convex stage 13 in which the center of the mounting surface is raised upward in the vertical direction from the outer peripheral portion, and the processing module 10C includes a concave stage 14 in which the center of the mounting surface is recessed downward in the vertical direction from the outer peripheral portion.

In the case where the direction of the warpage of a substrate W is recognized by the alignment module 50, the control device 90 of the substrate processing system 1A causes the substrate W to be transferred to any appropriate one of the processing modules 10A through 10D according to the state of the warpage of the substrate W. For example, the substrate W having no warpage is transferred to the processing module 10A or the processing module 10D, the substrate W having convex warpage is transferred to the processing module 10B, and the substrate W having concave warpage is transferred to the processing module 10C. Thus, the processing modules 10A through 10D can stably and accurately mount the substrate W transferred by the vacuum transfer robot 22 on the stages 12, 13, and 14 to perform substrate processing.

The substrate processing system 1A may be configured in such a manner that the mounting surfaces of the stages 12, 13, and 14 are deformable, and the deformation direction and the deformation amount of the mounting surfaces are adjusted according to the estimated warpage direction (convex warpage or concave warpage) and amount of warpage of the substrate W.

The technical idea and effects of the present disclosure described in the above embodiments will be described below.

The substrate transfer method according to the first aspect of the present disclosure includes (A) causing the transfer robot 33 to hold a substrate W and load the substrate W in the alignment module 50, and causing the transfer robot 33 to mount the substrate W on the stage (the rotary stage 52) of the alignment module 50 based on the transfer robot 33 moving past the stage of the alignment module 50; (B) causing the alignment module 50 to measure an eccentricity of the substrate W and estimating an amount of warpage of the substrate W based on the measured eccentricity of the substrate; and (C) causing the substrate W unloaded from the alignment module 50 to be loaded in a different module (the load lock module 40) based on the estimated amount of warpage of the substrate. The (A), (B), and (C) are performed in this order. In (A), the substrate W is moved obliquely downward relative to the stage of the alignment module 50.

According to the above, the substrate transfer method can estimate the warpage of the substrate W easily and accurately based on the eccentricity of the substrate W mounted on the stage (the rotary stage 52) of the alignment module 50. Thus, the substrate transfer method can appropriately transfer the substrate W in accordance with the estimated amount of warpage of the substrate W, and can achieve stabilization of transfer, improvement in accuracy of substrate processing, and the like.

In (A), the substrate W is moved obliquely downward before the control device 90 recognizes the mounting of the substrate W on the stage (the rotary stage 52) of the alignment module 50, and the substrate W is moved obliquely downward after the control device 90 recognizes the mounting of the substrate W on the stage of the alignment module 50. In this manner, the substrate transfer method can recognize various types of warpage of the substrate W by moving the substrate W obliquely downward from before the mounting of the substrate W on the stage to after the mounting.

The warpage of the substrate W exhibits one of a convex warpage state in which a center of the substrate protrudes upward in a vertical direction from an outer edge of the substrate and a concave warpage state in which the center of the substrate protrudes downward in the vertical direction from the outer edge of the substrate. In (B), the substrate W is determined have convex warpage or concave warpage based on a phase of an outer edge of the substrate W obtained through the measurement of the eccentricity of the substrate W performed by the alignment module 50. Thus, the substrate transfer method can accurately determine whether the substrate W has convex warpage or concave warpage based on the measurement result of the alignment module 50.

The other modules include the load lock module 40 capable of switching between an atmospheric atmosphere and a vacuum atmosphere, the vacuum transfer module 20 connected to the load lock module 40, and the plurality of processing modules 10 connected to the vacuum transfer module 20. In (C), the substrate W is transferred to the plurality of processing modules 10 via the load lock module 40 and the vacuum transfer module 20. Thus, the substrate transfer method can accurately transfer the substrate W to the target processing module 10 based on the amount of warpage of the substrate W.

At least one of the plurality of processing modules 10 has a convex mounting surface for the substrate W, and in the case where the substrate W is determined to have convex warpage in (B), the substrate W having convex warpage is transferred to the processing module 10B having the convex mounting surface in (C). Thus, the substrate transfer method can stably mount the substrate W having convex warpage on the stage 13 of the processing module 10B.

In at least one of the plurality of processing modules 10, the mounting surface of the substrate W is formed in a concave shape, and in the case where the substrate W is determined to have concave warpage in (B), the substrate W having convex warpage is transferred to the processing module 10C having the concave mounting surface in (C). Thus, the substrate transfer method can stably mount the substrate W having concave warpage on the stage 14 of the processing module 10C.

In (A), the substrate W is moved downward in the vertical direction before the control device 90 recognizes that the substrate W is mounted on the stage (the rotary stage 52) of the alignment module 50, and the substrate W is moved obliquely downward after the control device 90 recognizes that the substrate W is mounted on the stage of the alignment module 50. Thus, with the substrate transfer method, the amount of warpage of the substrate W having convex warpage can be recognized with high accuracy by moving the substrate W downward in the vertical direction before the substrate W is mounted on the stage and moving the substrate W obliquely downward after the substrate W is mounted on the stage.

In (B), the amount of warpage of the substrate W is calculated based on the eccentricity of the substrate W measured by the alignment module 50 and an angle of the obliquely downward moving direction of the substrate W. Thus, with the substrate transfer method, the amount of warpage of the substrate W can be calculated more easily and accurately.

In (C), movement correction is performed for the transfer robot 33 in the different module (the load lock module 40) based on the estimated amount of warpage of the substrate W, and the substrate W is mounted on the stage 42 of the different module. Thus, with the substrate transfer method, a positional displacement of the substrate W can be avoided when the warped substrate W is mounted on the stage 42 of the different module.

In (C), the mounting surface of the stage of the different module and the lower surface of the substrate are made to coincide with each other by adding the amount of warpage of the substrate when the substrate is moved to be mounted on the stage 42 of the different module (the load lock module 40). Thus, the substrate transfer method can accurately mount the warped substrate W on the stage 42 of the different module.

In (A), the transfer robot 33 inserts the outer edge of the substrate W by the clamp mechanism 344 on the end effector 34 supporting the substrate W before mounting the substrate W on the stage 42 of the alignment module 50, and transfers the substrate W while keeping the position of the substrate W with respect to the end effector 34 constant. Thus, the end effector 34 can transfer the substrate W while maintaining the position of the substrate W constant, and can accurately mount the substrate W on the rotary stage 52 or the like of the alignment module 50.

The second aspect of the present disclosure is the substrate processing system 1 including the transfer robot 33 configured to hold and transfer a substrate W, an alignment module 50 configured to measure an eccentricity of the substrate W, an different module (the load lock module 40) to which the substrate W unloaded from the alignment module 50 is transferred, and the control device 90 controls the following (A) to (C) in this order: (A) causing the transfer robot 33 to load the substrate W in the alignment module 50, and causing the transfer robot 33 to mount the substrate W on the stage (the rotary stage 52) of the alignment module 50 based on the transfer robot 33 moving past the stage of the alignment module 50; (B) causing the alignment module 50 to measure an eccentricity of the substrate W and estimating an amount of warpage of the substrate W based on the measured eccentricity of the substrate; and (C) causing the substrate W unloaded from the alignment module 50 to be loaded in the different module based on the estimated warpage amount of the substrate W. In (A), the substrate W is moved obliquely downward relative to the stage of the alignment module 50. Even with this aspect, the substrate processing system 1 can estimate the warpage of the substrate W easily and accurately.

The substrate transfer method and the substrate processing system 1 according to the embodiment disclosed herein are illustrative and non-restrictive in all respects. The embodiments may be modified and improved in various forms without departing from the scope and spirit of the appended claims. The matters described in the plurality of embodiments can be combined with each other within a range not inconsistent with each other.

This application claims priority to Japanese Patent Application No. 2022-193055 filed on December 1, 2022, the entire contents of which are incorporated herein by reference.

### REFERENCE SIGNS LIST

- 1: Substrate processing system
- 10: Processing module
- 33: Transfer robot
- 40: Load lock module
- 50: Alignment module
- 52: Rotary stage
- 90: Control device
- W: Substrate

## Claims

1. A substrate transfer method, comprising:
(A) causing a transfer robot to hold a substrate and to load the substrate in an alignment module, and causing the transfer robot to mount the substrate on a stage of the alignment module based on the transfer robot moving past the stage of the alignment module;
(B) causing the alignment module to measure an eccentricity of the substrate and estimating an amount of warpage of the substrate based on the measured eccentricity of the substrate; and
(C) causing the substrate unloaded from the alignment module to be loaded in a different module based on the estimated amount of warpage of the substrate,
(A), (B), and (C) being performed in this order, wherein
in (A), the substrate is moved obliquely downward relative to a stage of the alignment module.

2. The substrate transfer method according to claim 1, wherein
in (A), the substrate is moved obliquely downward before a control device recognizes mounting of the substrate on the stage of the alignment module, and the substrate is moved obliquely downward after the control device recognizes the mounting of the substrate on the stage of the alignment module.

3. The substrate transfer method according to claim 2, wherein
the warpage of the substrate exhibits one of a convex warpage state in which a center of the substrate protrudes upward in a vertical direction from an outer edge of the substrate or a concave warpage state in which the center of the substrate protrudes downward in the vertical direction from the outer edge of the substrate, and
in (B), the substrate is determined to have convex warpage or concave warpage based on a phase of an outer edge of the substrate obtained through the measurement of the eccentricity of the substrate performed by the alignment module.

4. The substrate transfer method according to claim 3, wherein
the different module includes
a load lock module configured to switch between an atmospheric atmosphere and a vacuum atmosphere,
a vacuum transfer module connected to the load lock module, and
a plurality of processing modules connected to the vacuum transfer module, wherein
in (C), the substrate is transferred to the plurality of processing modules via the load lock module and the vacuum transfer module.

5. The substrate transfer method according to claim 4, wherein
a surface for mounting the substrate is formed in a convex shape in at least one of the plurality of processing modules, and
in a case where the substrate is determined to have convex warpage in (B), the substrate having convex warpage is transferred to the processing module having the mounting surface having a convex shape, in (C).

6. The substrate transfer method according to claim 4, wherein
a surface for mounting the substrate is formed in a concave shape in at least one of the plurality of processing modules, and
in a case where the substrate is determined to have concave warpage in (B), the substrate having convex warpage is transferred to the processing module having the mounting surface having a concave shape, in (C).

7. The substrate transfer method according to claim 1, wherein
in (A), the substrate is moved downward in a vertical direction before the control device recognizes mounting of the substrate on the stage of the alignment module, and the substrate is moved downward in a vertical direction after the control device recognizes the mounting of the substrate on the stage of the alignment module.

8. The substrate transfer method according to any one of claims 1 to 7**,** wherein
in (B), the amount of warpage of the substrate is calculated based on the eccentricity of the substrate measured by the alignment module and an angle of the obliquely downward moving direction of the substrate.

9. The substrate transfer method according to any one of claims 1 to 7**,** wherein
in (C), a movement correction is performed for the transfer robot in the different module based on the estimated amount of warpage of the substrate, and the substrate is mounted on the stage of the other module.

10. The substrate transfer method according to claim 9**,** wherein
in (C), the mounting surface of the stage of the different module and the lower surface of the substrate are made to coincide with each other by adding the amount of warpage of the substrate when the substrate is moved to be mounted on the stage of the different module.

11. The substrate transfer method according to any one of claims 1 to 7**,** wherein
in (A), the transfer robot inserts an outer edge of the substrate on an end effector supporting the substrate with a clamp mechanism before the substrate is mounted on the stage of the alignment module, and transfers the substrate while keeping a position of the substrate with respect to the end effector constant.

12. A substrate processing system, comprising:
a transfer robot configured to hold and transfer a substrate;
an alignment module configured to measure an eccentricity of the substrate;
a different module to which the substrate unloaded from the alignment module is transferred; and
a control device, wherein
the control device is configured to control (A) to (C) in this order:
(A) causing the transfer robot to load the substrate in the alignment module, and causing the transfer robot to mount the substrate on a stage of the alignment module based on the transfer robot moving past the stage of the alignment module;
(B) causing the alignment module to measure an eccentricity of the substrate and estimating an amount of warpage of the substrate based on the measured eccentricity of the substrate; and
(C) causing the substrate unloaded from the alignment module to be loaded in a different module based on the estimated amount of warpage of the substrate, and
in (A), the substrate is moved obliquely downward relative to the stage of the alignment module.
